# EUROPEAN PATENT APPLICATION

(11) **EP 4 796 941 A1**
(43) Date of publication of application: **26.08.2026**
(21) Application number: 24918197.5
(22) Date of filing: 13.11.2024
(51) Int. Cl.: G01R 31/374

(54) **THERMAL DIFFUSION TESTING METHOD, TEST DEVICE, AND COMPUTER READABLE STORAGE MEDIUM**

(30) Priority: 17.01.2024 CN 202410069352
(71) Applicant: Contemporary Amperex Technology Co., Limited, Ningde, Fujian 352100 (CN)
(72) Inventor: JIA, Fengqiu, Ningde, Fujian 352100 (CN); TAN, Muyang, Ningde, Fujian 352100 (CN); LIN, Denghua, Ningde, Fujian 352100 (CN); QU, Yi, Ningde, Fujian 352100 (CN)
(74) Representative: Ran, Handong
(86) International application number: PCT/CN2024/131840
(87) International publication number: WO 2025/152588

(57) **Abstract**

Embodiments of the present application provide a thermal diffusion testing method, a test device, and a computer readable storage medium. The method comprises: triggering thermal runaway in a first battery cell within a test battery, wherein the power level of the test battery satisfies a first preset condition, and the temperature of the test battery satisfies a second preset condition; acquiring battery parameter information of a second battery cell within the test battery, wherein the second battery cell and the first battery cell satisfy a first positional relationship; and on the basis of the battery parameter information of the second battery cell, determining whether thermal diffusion occurs in the test battery. The method, the test device, and the computer readable storage medium provided in the embodiments of the present application can improve the reliability and accuracy of thermal diffusion testing.

## Description

### CROSS-REFERENCE TO RELATED APPLICATION

The present application claims priority to Chinese Patent Application No. 202410069352.6 filed on January 17, 2024 and entitled "THERMAL PROPAGATION TEST METHOD, TEST DEVICE, AND COMPUTER-READABLE STORAGE MEDIUM", which is incorporated herein by reference in its entirety.

### TECHNICAL FIELD

Embodiments of the present application relate to the technical field of battery testing, and in particular, to a thermal propagation test method, a test device, and a computer-readable storage medium.

### BACKGROUND

With the number of fire incidents involving electric vehicles on the market continuing to rise, the safety of electric vehicles has become a major concern. Most fire incidents involving electric vehicles are caused by thermal propagation in the battery. Therefore, during the battery development, there is an urgent need for a battery-level thermal propagation test to expose product defects and continuously improve the design and manufacturing process of batteries, so as to enhance product quality.

### SUMMARY

Embodiments of the present application provide a thermal propagation test method, a test device, and a computer-readable storage medium, thereby helping improve the reliability and accuracy of a thermal propagation test.

In a first aspect, a thermal propagation test method is provided, which includes: triggering thermal runaway of a first battery cell in a test battery, a charge level of the test battery meeting a first preset condition, and a temperature of the test battery meeting a second preset condition; acquiring battery parameter information of a second battery cell in the test battery, the second battery cell being in a first positional relationship with the first battery cell; and determining, based on the battery parameter information of the second battery cell, whether the test battery undergoes thermal propagation.

In the embodiments of the present application, the thermal runaway of the first battery cell in the test battery is triggered, and whether the test battery undergoes the thermal propagation is determined based on the battery parameter information of the second battery cell that is in the first positional relationship with the first battery cell in the test battery. Before triggering the thermal runaway of the first battery cell, the charge level of the test battery is strictly controlled to meet the first preset condition, and the temperature of the test battery is controlled to meet the second preset condition. This helps ensure the accuracy and reliability of the test results.

In a possible implementation, the temperature of the test battery meeting the second preset condition includes that the temperature of the test battery is not less than 40 °C.

In the embodiments, the temperature of the test battery is set to be not less than 40 °C, thereby helping cover the most extreme scenarios that may be encountered during later stages of application, thus making the test results more effective and reducing the risk of the thermal propagation.

In a possible implementation, the charge level of the test battery meeting the first preset condition includes that a state of charge of the test battery reaches 100%.

In the embodiments, before the thermal propagation test is performed on the test battery, the test battery is charged to 100% SOC, thereby helping ensure that the test battery is under conditions most likely to trigger the thermal propagation, thus making the results of the thermal propagation test more reliable.

In one possible implementation, the second battery cell being in the first positional relationship with the first battery cell includes that the second battery cell is adjacent to the first battery cell.

In the embodiments, when thermal runaway of a certain battery cell in the test battery is monitored, battery parameter information of battery cells adjacent to the battery cell undergoing the thermal runaway is monitored in real time. This facilitates earlier detection of thermal propagation in the test battery, thereby reducing the irreversible effects caused by the thermal propagation.

In one possible implementation, the first battery cell is proximal to a central position within the test battery, and/or the first battery cell is surrounded by other battery cells within the test battery.

In the embodiments, the first battery cell proximal to the central position within the test battery and/or surrounded by other battery cells is selected as an object to be triggered into the thermal runaway, such that the test battery is more likely to undergo the thermal propagation, thereby improving the reliability of the thermal propagation test.

In one possible implementation, before or after triggering the thermal runaway of the first battery cell in the test battery, the method further includes: activating a cooling system of the test battery.

In the embodiments, before or after triggering the thermal runaway of the first battery cell in the test battery, the cooling system of the test battery is activated. This helps take into account the capability of the test battery to handle the thermal runaway during the thermal propagation test, allowing batteries that undergo the thermal runaway but avoid the thermal propagation through activation of the cooling system to still enter the market, thereby reducing the probability of the thermal propagation while improving the yield of the batteries.

In a possible implementation, the cooling system is a water cooling system, and the method further includes: controlling the water cooling system to circulate water for a first preset duration, where the first preset duration is determined based on at least one type of information of the following information: rated energy of a low-voltage power supply provided by the test battery, a rated capacity of the low-voltage power supply provided by the test battery, a rated voltage of the low-voltage power supply provided by the test battery, an upper limit value of a state of charge at which the test battery operates, a lower limit value of the state of charge at which the test battery operates, and rated energy of a water pump.

In the embodiments, when the thermal runaway of a battery under test is triggered, generally, the water cooling system has no high voltage and does not provide refrigeration for cooling, so heat will only be removed by water circulation. Therefore, controlling a duration of the water circulation in the water cooling system is beneficial for more accurately verifying the capability of the test battery to handle the thermal runaway during the thermal propagation test.

In a possible implementation, the first preset duration is determined based on the following formulas: W1 = C × V × (SOC₁ - SOC₂), and T = W₁/W₂ × 60, where W1 represents the rated energy of the low-voltage power supply provided by the test battery, C represents the rated capacity of the low-voltage power supply provided by the test battery, V represents the rated voltage of the low-voltage power supply provided by the test battery, SOC₁ represents the upper limit value of the state of charge at which the test battery operates, SOC₂ represents the lower limit value of the state of charge at which the test battery operates, W₂ represents the rated energy of the water pump, and T represents the first preset duration.

In a possible implementation, determining, based on the battery parameter information of the second battery cell, whether the test battery undergoes the thermal propagation includes: determining that the test battery undergoes the thermal propagation in the case that it is monitored that the battery parameter information meets at least one type of the following conditions: a voltage of the second battery cell drops to a value lower a preset proportion of an initial voltage, a temperature of the second battery cell reaches a temperature threshold, and a temperature rise rate of the second battery cell is not less than a first threshold for more than a second preset duration.

In the embodiments, when at least one of the following conditions is met, including that the voltage of the second battery cell drops to the preset proportion of the initial voltage, the temperature of the second battery cell reaches the temperature threshold, and the temperature rise rate of the second battery cell is greater than or equal to the first threshold for more than the second preset duration, it is determined that the test battery undergoes the thermal propagation, such that the performance of the test battery is relatively accurately evaluated.

In one possible implementation, the method further includes: heating, before triggering the thermal runaway of the first battery cell in the test battery, the test battery to meet the second preset condition.

In the embodiments, after heating the test battery until the second preset condition is met, the thermal propagation test is then performed on the test battery, thereby helping cover the most severe scenarios that may be encountered during later stages of application, thus making the test results more effective and reducing the risk of the thermal propagation.

In a possible implementation, the method further includes: controlling, in the case that it is determined that the test battery undergoes the thermal propagation, a heating device to be removed from a test platform, the heating device being configured to heat the test battery to meet the second preset condition.

In the embodiments, in the case that it is determined that the test battery undergoes the thermal propagation, the heating device is removed from the test platform, which will reduce the influence of the thermal propagation on the heating device.

In a possible implementation, triggering the thermal runaway of the first battery cell in the test battery includes: activating a heating apparatus in contact with a surface of the first battery cell, such that the first battery cell meets at least one type of the following conditions: a voltage of the first battery cell drops to a value lower a preset proportion of an initial voltage, a temperature of the first battery cell reaches a temperature threshold, and a temperature rise rate of the first battery cell is not less than a first threshold for more than a second preset duration.

In the embodiments, the use of the method that triggers the thermal runaway will reduce the probability of damaging the battery cell or an external structure or a sealing structure of the test battery, thereby allowing a simulated thermal runaway behavior to be as realistic as possible.

In a possible implementation, the test battery is a battery provided with a customized vehicle frame.

In the embodiments, by providing the test battery with the customized vehicle frame, the environment for the thermal propagation test will be more realistic, and the test results will be more accurate.

In a second aspect, a test device is provided. The test device is configured to perform a thermal propagation test on a test battery, and the test device includes a processor; the processor is configured to trigger thermal runaway of a first battery cell in the test battery, a charge level of the test battery meeting a first preset condition, and a temperature of the test battery meeting a second preset condition; the processor is further configured to acquire battery parameter information of a second battery cell in the test battery, the second battery cell being in a first positional relationship with the first battery cell; and the processor is further configured to determine, based on the battery parameter information of the second battery cell, whether the test battery undergoes thermal propagation.

In a possible implementation, the temperature of the test battery meeting the second preset condition includes that the temperature of the test battery is not less than 40 °C.

In a possible implementation, the charge level of the test battery meeting the first preset condition includes that a state of charge of the test battery reaches 100%.

In one possible implementation, the second battery cell being in the first positional relationship with the first battery cell includes that the second battery cell is adjacent to the first battery cell.

In one possible implementation, the first battery cell is proximal to a central position within the test battery, and/or the first battery cell is surrounded by other battery cells within the test battery.

In one possible implementation, the processor is further configured to: activate, before or after triggering the thermal runaway of the first battery cell in the test battery, a cooling system of the test battery.

In a possible implementation, the cooling system is a water cooling system, and the processor is further configured to: control the water cooling system to circulate water for a first preset duration, where the first preset duration is determined based on at least one type of information of the following information: rated energy of a low-voltage power supply provided by the test battery, a rated capacity of the low-voltage power supply provided by the test battery, a rated voltage of the low-voltage power supply provided by the test battery, an upper limit value of a state of charge at which the test battery operates, a lower limit value of the state of charge at which the test battery operates, and rated energy of a water pump.

In a possible implementation, the first preset duration is determined based on the following formulas: W₁ = C × V × (SOC₁ - SOC₂), and T = W₁/W₂ × 60, where W₁ represents the rated energy of the low-voltage power supply provided by the test battery, C represents the rated capacity of the low-voltage power supply provided by the test battery, V represents the rated voltage of the low-voltage power supply provided by the test battery, SOC₁ represents the upper limit value of the state of charge at which the test battery operates, SOC₂ represents the lower limit value of the state of charge at which the test battery operates, W₂ represents the rated energy of the water pump, and T represents the first preset duration.

In one possible implementation, the processor is specifically configured to: determine that the test battery undergoes the thermal propagation in the case that it is monitored that the battery parameter information meets at least one type of the following conditions: a voltage of the second battery cell drops to a value lower a preset proportion of an initial voltage, a temperature of the second battery cell reaches a temperature threshold, and a temperature rise rate of the second battery cell is not less than a first threshold for more than a second preset duration.

In a possible implementation, the processor is specifically configured to: control, before triggering the thermal runaway of the first battery cell in the test battery, a heating device to heat the test battery to meet the second preset condition.

In a possible implementation, the processor is further configured to: control, in the case that it is determined that the test battery undergoes the thermal propagation, the heating device to be removed from a test platform.

In one possible implementation, the processor is specifically configured to: activate a heating apparatus in contact with a surface of the first battery cell, such that the first battery cell meets at least one type of the following conditions: a voltage of the first battery cell drops to a value lower a preset proportion of an initial voltage, a temperature of the first battery cell reaches a temperature threshold, and a temperature rise rate of the first battery cell is not less than a first threshold for more than a second preset duration.

In a possible implementation, the test battery is a battery provided with a customized vehicle frame.

In a third aspect, a chip is provided, which includes: a processor configured to invoke a computer program from a memory and run the computer program, such that a device provided with the chip performs the method according to the first aspect and any one of the possible implementations of the first aspect.

In a fourth aspect, a computer program is provided. The computer program causes a computer to perform the method according to the first aspect and any one of the possible implementations of the first aspect.

In a fifth aspect, a computer-readable storage medium is provided. The computer-readable storage medium is configured to store a computer program, and the computer program causes a computer to perform the method according to the first aspect and any one of the possible implementations of the first aspect.

In a sixth aspect, a computer program product is provided. The computer program product includes a computer program instruction. The computer program instruction causes a computer to perform the method according to the first aspect and any one of the possible implementations of the first aspect.

### BRIEF DESCRIPTION OF THE DRAWINGS

To more clearly illustrate the technical solutions according to embodiments of the present application, the drawings required for illustrating the embodiments of the present application are briefly described below. Apparently, the drawings in the following description illustrate merely some embodiments of the present application, and those of ordinary skill in the art may still derive other drawings from these drawings without creative efforts.
FIG. 1 shows a schematic exploded diagram of a test battery according to an embodiment of the present application;
FIG. 2 shows a first schematic block diagram of a thermal propagation test method according to an embodiment of the present application;
FIG. 3 shows a second schematic block diagram of a thermal propagation test method according to an embodiment of the present application;
FIG. 4 shows a third schematic block diagram of a thermal propagation test method according to an embodiment of the present application;
FIG. 5 shows a fourth schematic block diagram of a thermal propagation test method according to an embodiment of the present application;
FIG. 6 shows a fifth schematic block diagram of a thermal propagation test method according to an embodiment of the present application;
FIG. 7 shows a schematic diagram of mounting positions of a heating apparatus and a temperature sensor in a method for triggering thermal runaway by heating, according to an embodiment of the present application;
FIG. 8 shows a schematic diagram of a positional relationship between a needle penetration point and a temperature sensor in a method for triggering thermal runaway by needle penetration, according to an embodiment of the present application;
FIG. 9 shows a schematic flowchart of a thermal propagation test method according to an embodiment of the present application; and
FIG. 10 shows a schematic block diagram of a test device according to an embodiment of the present application.

### DETAILED DESCRIPTION

Implementations of the present application will be described in further detail with reference to the drawings and embodiments. The following detailed description of the embodiments and the drawings are used for the exemplary illustration of the principles of the present application, but are not intended to limit the scope of the present application. That is, the present application is not limited to the described embodiments.

In the description of the present application, it should be noted that, unless otherwise specified, "a plurality of" means two or more. In addition, the terms "first", "second", "third", and the like are used for descriptive purposes only, and should not be construed as indicating or implying relative importance.

At present, judging from the trends in the market, the application of power batteries is becoming increasingly widespread. Power batteries are not only applied in energy storage systems, such as hydropower, thermal power, wind power, and solar power stations, but also widely applied in electric transportation vehicles, such as electric bicycles, electric motorcycles, electric vehicles, and electric trucks, and may even be applied in a plurality of fields, such as the military field and the aerospace field. With the continuous expansion of the application field of power batteries, the market demand for power batteries is also continuously increasing.

Due to reasons such as manufacturing defects or improper use of batteries, the batteries may undergo thermal runaway in extreme cases, resulting in an increase in the internal temperature of the batteries, and may further cause a chain reaction of thermal runaway in severe cases, that is, thermal propagation or thermal spread, resulting in battery fire or explosion. Since thermal runaway may not be completely avoided, it is only possible to reduce the likelihood of its occurrence or mitigate the damage caused after thermal runaway. Therefore, during the battery development, thermal propagation tests are generally performed on the batteries to expose product defects, and the design and manufacturing processes of the batteries are continuously improved to mitigate the damage caused after thermal runaway and to improve battery quality. Currently, results of thermal propagation tests often fail to accurately assess the safety of the batteries.

In view of this, the embodiments of the present application provide a thermal propagation test method. Thermal runaway of a first battery cell in a test battery is triggered, and whether the test battery undergoes thermal propagation is determined based on battery parameter information of a second battery cell that is in a first positional relationship with the first battery cell in the test battery. Before triggering the thermal runaway of the first battery cell, a charge level of the test battery is strictly controlled to meet a first preset condition, and a temperature of the test battery is controlled to meet a second preset condition. This helps ensure the accuracy and reliability of the test results.

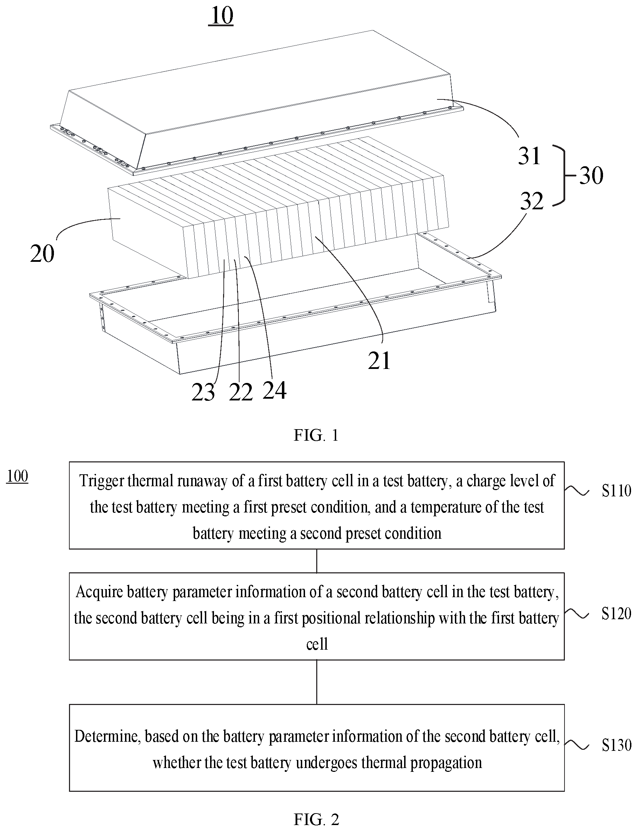

FIG. 1 shows a schematic structural diagram of a test battery 10 according to an embodiment of the present application. As shown in FIG. 1, the test battery 10 may include a plurality of battery cells 20. The test battery 10 further includes a case 30, and the interior of the case 30 is a hollow structure. The plurality of battery cells 20 are accommodated in the case 30. FIG. 1 shows a possible implementation of the case 30 according to the embodiments of the present application. As shown in FIG. 1, the case 30 may include two parts, herein referred to as a first part 31 and a second part 32, and the first part 31 and the second part 32 are snap-fitted together. The shapes of the first part 31 and the second part 32 may be determined based on the shape of the combination of a plurality of battery cells 20.

FIG. 2 shows a schematic block diagram of a thermal propagation test method 100 according to an embodiment of the present application. Optionally, the method 100 may be performed by a test device. For example, the test device may include a host computer. As shown in FIG. 2, the method 100 includes some or all of the following contents.

In S110, thermal runaway of a first battery cell in a test battery is triggered, a charge level of the test battery meeting a first preset condition, and a temperature of the test battery meeting a second preset condition.

In S120, battery parameter information of a second battery cell in the test battery is acquired, the second battery cell being in a first positional relationship with the first battery cell.

In S130, whether the test battery undergoes thermal propagation is determined based on the battery parameter information of the second battery cell.

The test battery in the embodiments of the present application may be as shown in FIG. 1. That is, the test battery may include a plurality of battery cells, and the plurality of battery cells may include at least a first battery cell and a second battery cell.

A thermal propagation test refers to a test for evaluating the potential safety risk of thermal propagation in a test battery caused by thermal runaway of a single battery cell. In the embodiments of the present application, when the thermal propagation test is performed on the test battery, the thermal runaway of the first battery cell in the test battery may be triggered first, then the battery parameter information of the second battery cell in the test battery is acquired, and finally whether the test battery undergoes the thermal propagation is determined based on the battery parameter information of the second battery cell.

In some embodiments, whether the test battery undergoes the thermal propagation may be determined by determining whether the second battery cell also undergoes thermal runaway. For example, whether the second battery cell undergoes the thermal runaway may be determined by determining whether a temperature of the second battery cell reaches a certain value, such that whether the test battery undergoes the thermal propagation is determined.

In some other embodiments, whether the test battery undergoes the thermal propagation may be further determined by determining whether the pressure in the test battery reaches a certain value. In other embodiments, whether the test battery undergoes the thermal propagation may be further determined by determining whether the concentration of smoke in the test battery reaches a certain value. How to determine whether the test battery undergoes the thermal propagation is not specifically limited in the embodiments of the present application.

In the embodiments of the present application, before triggering the thermal runaway of the first battery cell in the test battery, the charge level of the test battery is set to meet the first preset condition, and the temperature of the test battery is set to meet the second preset condition. The first preset condition and the second preset condition may be preset based on different actual operating conditions of the battery, so as to cover the actual worst operating conditions as much as possible. In addition, before the thermal propagation test is performed on the test battery, the positional relationship between the first battery cell and the second battery cell also needs to be preset. For example, the first battery cell is spaced apart from the second battery cell by a preset number of battery cells. Once it is determined that the first battery cell undergoes the thermal runaway, the second battery cell is found based on the preset positional relationship, and the battery parameter information of the second battery cell is acquired. In this case, before the thermal propagation test is performed on the test battery, each battery cell in the test battery may need to be modified. For example, each battery cell is internally provided with a heating apparatus configured to trigger thermal runaway, and each battery cell is provided with a sensor configured to acquire battery parameter information. The airtightness after modification should meet the design requirements.

In some other embodiments, the first battery cell and the second battery cell may also be directly specified before the thermal propagation test is performed on the test battery. Once it is determined that the first battery cell undergoes the thermal runaway, the battery parameter information of the second battery cell is directly acquired. In this case, before the thermal propagation test is performed on the test battery, it may only be necessary to internally provide the first battery cell with the heating apparatus configured to trigger thermal runaway, and to provide the first battery cell and the second battery cell with sensors configured to acquire battery parameter information, without modifying other battery cells in the test battery.

The battery parameter information in the embodiments of the present application refers to parameter information related to the battery cell. More specifically, the battery parameter information refers to parameter information that may be used to determine whether the thermal runaway occurs. For example, the battery parameter information may be voltage information, temperature information, pressure information, or the like. In some embodiments, the battery parameter information may be acquired using a sensor. For example, voltage information may be acquired using a voltage sensor, temperature information may be acquired using a temperature sensor, and pressure information may be acquired using a pressure sensor. Further, the sensor may transmit the acquired battery parameter information to a host computer, such that the host computer determines whether a certain battery cell in the test battery undergoes thermal runaway, or whether the test battery undergoes the thermal propagation.

In the embodiments of the present application, the thermal runaway of the first battery cell in the test battery is triggered, and whether the test battery undergoes the thermal propagation is determined based on the battery parameter information of the second battery cell that is in the first positional relationship with the first battery cell in the test battery. Before triggering the thermal runaway of the first battery cell, the charge level of the test battery is strictly controlled to meet the first preset condition, and the temperature of the test battery is controlled to meet the second preset condition. This helps ensure the accuracy and reliability of the test results.

In some embodiments, the temperature of the test battery meeting the second preset condition includes that the temperature of the test battery is not less than 40 °C.

Generally, for the electric transportation vehicles described above, the higher an ambient temperature, the more likely a battery is to undergo thermal propagation. For example, in a hot summer, a battery in a vehicle is generally more prone to thermal propagation. During the battery development, if the thermal propagation test for the battery mounted on the vehicle is performed at a room temperature, the test results may contain errors. For example, if the test battery is found to be not prone to the thermal propagation in the thermal propagation test at room temperature, but the vehicle provided with the test battery is exposed to high-temperature scenarios for an extended period, such as a sun exposure scenario during hot summer, the test battery may still undergo thermal propagation, thereby rendering the thermal propagation test ineffective during the battery development. Therefore, in this case, the thermal propagation test is performed on the test battery at a high temperature. For example, the temperature of the test battery is set to be not less than 40 °C, thereby helping cover the most extreme scenarios that may be encountered during later stages of application, thus making the test results more effective and reducing the risk of the thermal propagation.

Optionally, the temperature of the test battery may be between 40 °C and 50 °C. For example, the temperature of the test battery is 40°, 45 °C, or 50°.

In some embodiments, the temperature of the test battery meeting the second preset condition further includes that the temperature of the test battery reaches 55 °C or reaches a maximum operating temperature specified by a manufacturer. For example, if the maximum operating temperature specified by the manufacturer is 60°, the temperature of the test battery will be set to 60° before the thermal propagation test.

In actual vehicle scenarios, the vehicle records vehicle data, such as temperature data of the battery. However, this data does not differentiate between actual application scenarios of the vehicle. Therefore, by performing in-depth analysis and inference on the vehicle data, the second preset condition will ultimately be defined.

The definition logic of the second preset condition will be described in detail below with reference to specific embodiments.

Data source: More than 200,000 passenger vehicles are selected, covering more than 15 vehicle models. The chemical system of the battery used includes an NCM ternary lithium material and a lithium iron phosphate LFP material. The 200,000 passenger vehicles were mainly used in places such as Jilin, Beijing, Shanghai, and Guangzhou.

Data filtering: The application scenarios of a vehicle are mainly as follows: 1. transportation/storage; 2. vehicle assembly; 3. (high-load) driving; 4. (low-load) driving; 5. (high-load) charging; 6. (low-load) charging; 7. (grid-connected) parking; 8. (grid-disconnected) parking; 9. after-sales maintenance; 10. special scenarios (car wash/battery swap, etc.). Considering that a load, a state of charge (SOC), and a battery temperature are characteristic parameters of harsh scenarios, typical severe scenarios of thermal runaway of a battery are identified through filtering as: high-temperature and high-load charging (fast charging), high-temperature and high-load driving (discharging), and grid-disconnected parking (under sun exposure). A high load means that a large current flows through. For example, a current/capacity being greater than 1 is considered as a high load. In addition, since the vehicle only records internal temperature data of the battery and lacks the ambient temperature of the battery, an air temperature is used as a reference, and the afternoon hours in summer (11:00 to 18:00) are considered high-temperature conditions. Specifically, the temperature data recorded by the 200,000 passenger vehicles described above in the afternoons of June 2022 to August 2022 under the three typical severe scenarios described above may be selected. In addition, since the battery is in a sleeping state during vehicle parking, and the internal temperature data of the battery is not detectable, the interval between a timing corresponding to a first frame upon wake-up and a timing corresponding to a last frame when parking may be used as a rest time. When the rest time is greater than 3h, it is considered that thermal equilibrium has been reached, and the battery is subject to sun exposure conditions.

Data processing: Since there are 3 typical severe scenarios in actual use, in order to obtain weighted results, durations of data of the three scenarios need to be compared to obtain proportions, and finally a weighted value of temperature is obtained, as shown in Table 1.

**Table 1**

| Typical scenarios | Data | | Scenario proportions | Weighted results |
|---|---|---|---|---|
| 1. High-temperature and high-load driving (discharging) | 3σ=51.3°C | Mean value = 40.6 °C | 5.4 | 3σ = 47.3 °C |
| | | | | Mean value = 37.6 °C |
| 2. High-temperature and high-load charging (fast charging) | 3σ=52.9°C | Mean value = 41.1 °C | 1 | |
| 3. Parking under sun exposure (grid-disconnected parking) | 3σ=45.4°C | Mean value = 36.2 °C | 13.6 | |

Definition of the second preset condition: As shown in Table 1, 3σ = 47.3 °C, and Mean value = 37.6 °C. Considering that the capacity ranges of different batteries vary, after rounding, the temperature falls within 40 °C to 50 °C. That is, the temperature of the test battery meeting the second preset condition means that the temperature of the test battery is at least not less than 40 °C.

In another embodiment of the present application, the thermal propagation test for the test battery may also be performed at a room temperature. That is, before the thermal propagation test, the temperature of the test battery is at a room temperature. The room temperature may be generally defined as a temperature below 0° and less than 40°. For example, before the thermal propagation test, the temperature of the test battery is 10°, 15°, 20°, 25°, or the like.

In some embodiments, the charge level of the test battery meeting the first preset condition includes that an SOC of the test battery reaches 100%. In other words, the test battery needs to be charged to full capacity.

Specifically, standard charging may be performed on the test battery with reference to GB38031. That is, the battery is first discharged at a current not less than I3 specified by the manufacturer until the battery reaches a discharge termination voltage specified in technical conditions of the manufacturer, and is left to stand for 1 h (or a rest time not greater than 1 h provided by the manufacturer). Then, charging is performed according to a charging method provided by the manufacturer. If the manufacturer does not provide the charging method, a detection organization and the manufacturer determine a suitable charging method through negotiation, or charging is performed based on the following method: charging the test battery at a constant current not less than I3 as specified by the manufacturer until the test battery reaches a charge termination voltage specified in the technical conditions of the manufacturer; switching to constant voltage charging; stopping charging when a charging current drops to 0.05I1; and after charging, resting the battery for 1 h (or for a rest time of 1 h provided by the manufacturer), where I1 is a rated current and I3 is 1/3 of the rated current.

In the embodiments, before the thermal propagation test is performed on the test battery, the test battery is charged to 100% SOC, thereby helping ensure that the test battery is under conditions most likely to trigger the thermal propagation, thus making the results of the thermal propagation test more reliable.

In other embodiments, the thermal propagation test may also be performed when the SOC of the test battery reaches other values. For example, the thermal propagation test may be performed on the test battery when the SOC of the test battery reaches 50%, 60%, 70%, 75%, 80%, 85%, 90%, or 95%. In the actual use of the vehicle, the probability of the battery being under the most severe scenarios, for example, the battery remains fully charged for a long time in a high-temperature environment, is low. Therefore, the SOC of the test battery will be appropriately reduced during the test, thereby helping improve the yield of the battery.

In some embodiments, the second battery cell being in the first positional relationship with the first battery cell includes that the second battery cell is adjacent to the first battery cell.

Generally, when a certain battery cell in the battery undergoes thermal runaway, if the thermal runaway problem is not addressed in time, it is very likely to propagate to other battery cells in the battery, thereby causing other battery cells to undergo thermal runaway. In particular, battery cells adjacent to the battery cell undergoing the thermal runaway are the first and most likely to be affected. Therefore, in the embodiments of the present application, when thermal runaway of a certain battery cell in the test battery is monitored, battery parameter information of the battery cells adjacent to the battery cell undergoing the thermal runaway is monitored in real time. This facilitates earlier detection of the thermal propagation in the test battery, thereby reducing the irreversible effects caused by the thermal propagation.

In other embodiments, the second battery cell may not be adjacent to the first battery cell. That is, when the thermal runaway of the first battery cell in the test battery is monitored, the battery parameter information of the second battery cell spaced apart from the first battery cell by the preset number of battery cells will also be monitored, and whether the thermal propagation occurs will also be determined.

In some embodiments, the first battery cell is proximal to a central position within the test battery, and/or the first battery cell is surrounded by other battery cells within the test battery.

For example, if the test battery 10 in FIG. 1 includes 25 battery cells arranged in a first direction X, the first battery cell may be the 13th battery cell arranged in sequence from one end to the other end in the first direction X. That is, the first battery cell is a battery cell 21 in FIG. 1. For another example, the first battery cell may also be a battery cell 22 in FIG. 1, which is surrounded by a battery cell 23 and a battery cell 24.

In the embodiments, the first battery cell proximal to the central position within the test battery and/or surrounded by other battery cells is selected as an object to be triggered into the thermal runaway, such that the test battery is more likely to undergo the thermal propagation, thereby improving the reliability of the thermal propagation test.

In some other embodiments, the first battery cell may also be selected in the following manners: 1. selecting a battery cell at a position where heat dissipation and exhaust are hindered, the position being usually the central position of the test battery; 2. selecting a battery cell at a position where the risk of high-voltage arcing is high, the position being usually proximal to a high-voltage port; 3. selecting a battery cell at a position where a water cooling system is weak, the position being a weak position of a water cooling pipeline.

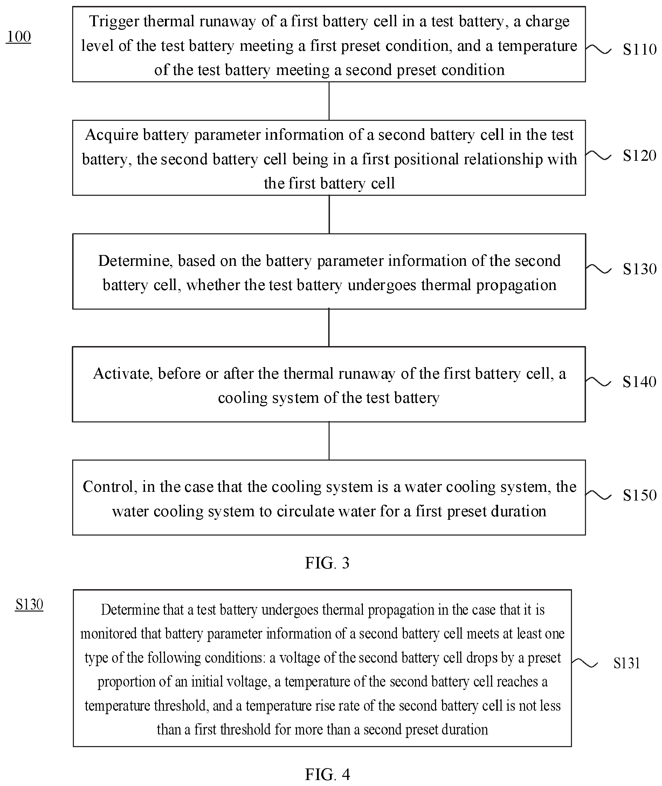

In some embodiments, as shown in FIG. 3, before or after triggering the thermal runaway of the first battery cell in the test battery, the method 100 further includes: In S140, a cooling system of the test battery is activated.

Optionally, the cooling system may be a liquid cooling system, an air cooling system, or a direct cooling system. In the air cooling system, air may be used as a heat exchange medium to cool the battery. In the liquid cooling system, liquid is used as a heat exchange medium to cool the battery. In the direct cooling system, a refrigerant is used as a heat exchange medium to absorb heat during gas-liquid phase change to cool the battery.

In some embodiments, before triggering the thermal runaway of the first battery cell in the test battery, the cooling system of the test battery may be activated. As such, the cooling system may be used to reduce the probability of the thermal runaway or the probability of the thermal propagation during the entire thermal propagation test.

In some other embodiments, after triggering the thermal runaway of the first battery cell in the test battery, the cooling system of the test battery may be activated, such that the cooling system is used to reduce the effects caused by the thermal runaway, for example, to reduce the probability of the thermal propagation.

In the embodiments, before or after triggering the thermal runaway of the first battery cell in the test battery, the cooling system of the test battery is activated. This helps take into account the capability of the test battery to handle the thermal runaway during the thermal propagation test, allowing batteries that undergo the thermal runaway but avoid the thermal propagation through activation of the cooling system to still enter the market, thereby reducing the probability of the thermal propagation while improving the yield of the batteries.

In some embodiments, as shown in FIG. 3, the cooling system is a water cooling system, and the method 100 further includes: In S150, the water cooling system is controlled to circulate water for a first preset duration, where the first preset duration is determined based on at least one type of information of the following information: rated energy of a low-voltage power supply provided by the test battery, a rated capacity of the low-voltage power supply provided by the test battery, a rated voltage of the low-voltage power supply provided by the test battery, an upper limit value of an SOC at which the test battery operates, a lower limit value of the SOC at which the test battery operates, and rated energy of a water pump.

In the actual use of the vehicle, when the thermal runaway is triggered, the battery reports a fault to the vehicle and requests high-voltage disconnection. When the water cooling system no longer has high voltage, the compressor will not be activated, meaning that there is no cooling power. In this case, cooling would only rely on circulation through a water circulation pump. Since refrigeration and temperature reduction will not be achieved in this case, heat would only be removed by circulation. Therefore, execution needs to follow a vehicle strategy, taking into account the most severe operating conditions.

Similarly, during the thermal propagation test, whether water circulation of the water cooling system is activable will be first determined. If the water circulation of the water cooling system is not activable, the thermal propagation test is performed under the most severe operating conditions; that is, the test battery is set to a mode in which the water circulation is not triggerable. Once the thermal runaway of the first battery cell in the test battery is triggered, the water cooling system neither provides refrigeration nor circulates. For the test battery undergoing the thermal propagation test under this operating condition, the probability of the thermal propagation after entering the market is relatively low. If the water circulation of the water cooling system is activable, the test battery is set to a mode in which the water circulation is triggerable. Once the thermal runaway of the first battery cell in the test battery is triggered, the water cooling system only circulates water and does not provide refrigeration, and a water cooling flow rate may follow the vehicle strategy.

In some embodiments, determining whether the water circulation of the water cooling system is triggerable may be performed after triggering the thermal runaway of the first battery cell. Once it is determined that the water circulation of the water cooling system is triggerable, the water cooling system is controlled to perform water circulation; and once it is determined that the water circulation of the water cooling system is not triggerable, the water cooling system is controlled not to perform water circulation.

In some other embodiments, determining whether the water circulation of the water cooling system is triggerable may also be performed before triggering the thermal runaway of the first battery cell. Once it is determined that the water circulation of the water cooling system is triggerable, the subsequent thermal propagation test is performed in a mode in which the water circulation of the water cooling system is triggerable by default. If it is determined that the water circulation of the water cooling system is not triggerable, the subsequent thermal propagation test is performed in a mode in which the water circulation of the water cooling system is not triggerable by default.

Optionally, the first preset duration may also be preset with reference to an actual operating condition. In some embodiments, the first preset duration is less than 1 h. For example, the first preset duration may be 30 min.

In some embodiments, the first preset duration is determined based on the at least one type of information of the following information: the rated energy of the low-voltage power supply provided by the test battery, the rated capacity of the low-voltage power supply provided by the test battery, the rated voltage of the low-voltage power supply provided by the test battery, the upper limit value of the SOC at which the test battery operates, the lower limit value of the SOC at which the test battery operates, and the rated energy of the water pump.

The low-voltage power supply provided by the test battery refers to a direct current power supply provided by the test battery, and is generally configured to provide a stable direct current power supply for an electronic device, a sensor, a controller, and the like. The rated energy of the low-voltage power supply provided by the test battery refers to the maximum electrical energy or energy that may be provided by the direct current power supply provided by the test battery. The rated capacity of the low-voltage power supply provided by the test battery refers to an output power of the direct current power supply provided by the test battery at a rated voltage and a rated current. Similarly, the rated voltage of the low-voltage power supply provided by the test battery refers to a rated voltage of the direct current power supply provided by the test battery. For example, the rated voltage is 220 V. The rated energy of the water pump generally refers to the maximum flow and head that the water pump may provide under specified conditions.

The upper limit value of the SOC at which the test battery operates depends on the performance and the service life of the test battery. For example, generally, the upper limit value of the SOC at which the battery operates should be between 80% and 90%. The lower limit value of the SOC at which the test battery operates depends on the type and the performance of the test battery. For example, for lead-acid batteries, the lower limit value of the SOC is generally 10%, while for lithium-ion batteries, the lower limit value of the SOC is generally 0%.

In the embodiments, when the thermal runaway of a battery under test is triggered, generally, the water cooling system has no high voltage and does not provide refrigeration for cooling, so heat will only be removed by water circulation. Therefore, controlling a duration of the water circulation in the water cooling system is beneficial for more accurately verifying the capability of the test battery to handle the thermal runaway during the thermal propagation test.

In some embodiments, the first preset duration is determined based on the following formulas: W₁ = C × V × (SOC₁ - SOC₂), and T = W₁/W₂ × 60, where W1 represents the rated energy of the low-voltage power supply provided by the test battery, with a unit of wh, C represents the rated capacity of the low-voltage power supply provided by the test battery, with a unit of Ah, V represents the rated voltage of the low-voltage power supply provided by the test battery, with a unit of V, SOC₁ represents the upper limit value of the SOC at which the test battery operates, with a unit of %, SOC₂ represents the lower limit value of the SOC at which the test battery operates, with a unit of %, W₂ represents the rated energy of the water pump, with a unit of wh, and T represents the first preset duration, that is, the duration of the water circulation when powered only by the low-voltage power supply, with a unit of min.

In some embodiments, as shown in FIG. 4, S130, that is, determining, based on the battery parameter information of the second battery cell, whether the test battery undergoes the thermal propagation includes: In S131, it is determined that the test battery undergoes the thermal propagation in the case that it is monitored that the battery parameter information of the second battery cell meets at least one type of the following conditions: a voltage of the second battery cell drops to a preset proportion of an initial voltage, a temperature of the second battery cell reaches a temperature threshold, and a temperature rise rate of the second battery cell is not less than a first threshold for more than a second preset duration.

That is, a voltage sensor and a temperature sensor may be disposed in the second battery cell. After triggering the thermal runaway in the first battery cell, the voltage sensor and/or the temperature sensor in the second battery cell will monitor the voltage and/or the temperature of the second battery cell in real time, and will synchronously upload voltage data and/or temperature data to the host computer. The host computer further determines whether the voltage data and/or the temperature data meet the above conditions. Once it is determined that the voltage data and/or the temperature data of the second battery cell meet one of the above conditions, the second battery cell is determined to be affected by the first battery cell, and then the test battery is determined to undergo the thermal propagation.

In some embodiments, it may be necessary to determine only one of the above conditions based on the battery parameter information of the second battery cell. For example, it may be sufficient to determine whether the voltage of the second battery cell drops to the preset proportion of the initial voltage. For another example, it may be sufficient to determine whether the temperature of the second battery cell reaches the temperature threshold. For another example, it may be sufficient to determine whether the temperature rise rate of the second battery cell is not less than the first threshold for more than the second preset duration.

It should be understood that if any of the above conditions is not met, in order to ensure the reliability of the thermal propagation, the above conditions may be determined together. If at least two of the above conditions are not met, it is considered that the second battery cell does not undergo the thermal runaway. For example, when the voltage of the second cell drops to the preset proportion of the initial voltage and the temperature of the second battery cell reaches the temperature threshold, it is considered that the second battery cell undergoes the thermal runaway. For another example, when the temperature of the second battery cell reaches the temperature threshold and the temperature rise rate of the second battery cell is not less than the first threshold for more than the second preset duration, it is considered that the second battery cell undergoes the thermal runaway.

In some embodiments, determining, based on the battery parameter information of the second battery cell, whether the test battery undergoes the thermal propagation includes: determining that the test battery undergoes the thermal propagation in the case that it is monitored that the battery parameter information of the second battery cell meets the at least one type of the following conditions: the voltage of the second battery cell drops to a value lower than 25% of the initial voltage, the temperature of the second battery cell reaches the maximum operating temperature specified by the manufacturer, and the temperature rise rate of the second battery cell is not less than 1 °C/s for more than 3 s.

It should be understood that the preset proportion, the temperature threshold, the first threshold, and the second preset duration may be adjusted based on actual situations.

In the embodiments, when at least one of the following conditions is met, including that the voltage of the second battery cell drops to the preset proportion of the initial voltage, the temperature of the second battery cell reaches the temperature threshold, and the temperature rise rate of the second battery cell is not less than the first threshold for more than the second preset duration, it is determined that the test battery undergoes the thermal propagation, such that the performance of the test battery is relatively accurately evaluated.

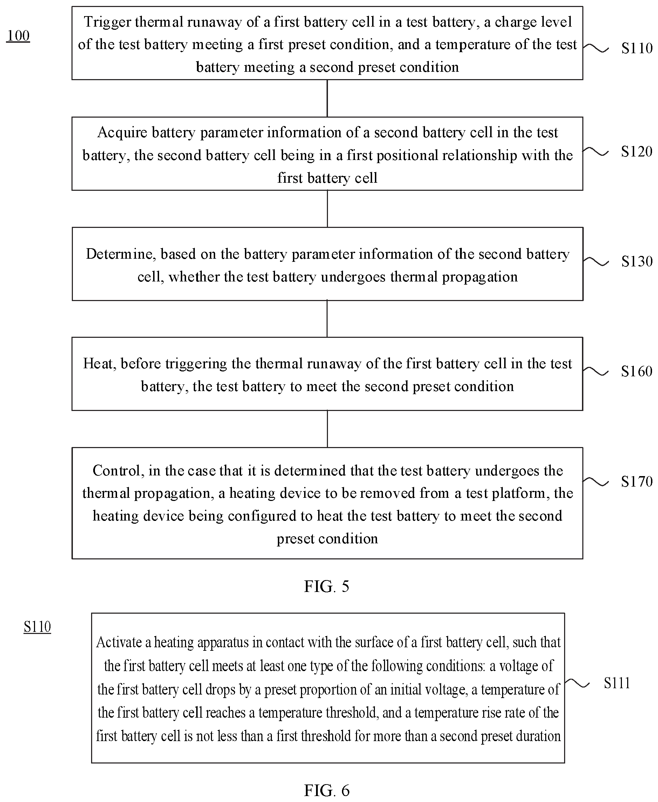

In some embodiments, as shown in FIG. 5, the method 100 further includes: In S160, before triggering the thermal runaway of the first battery cell in the test battery, the test battery is heated to meet the second preset condition.

Optionally, before performing the thermal propagation test, a heating device may be used to preheat the test battery. For example, the heating device may be an oven, in which the test battery may be placed, and a temperature of the oven may be set. For example, the temperature of the oven may be set to be greater than or equal to 55 °C, and the oven is activated to heat the test battery. When the temperature sensor inside the test battery monitors that the temperature of the test battery reaches 55 °C, the heating of the test battery by the oven is stopped.

If an oven is not available in the test environment, the test battery may also be heated by means of water-cooling heating until the second preset condition is met.

In the embodiments, after heating the test battery until the second preset condition is met, the thermal propagation test is then performed on the test battery, thereby helping cover the most severe scenarios that may be encountered during later stages of application, thus making the test results more effective and reducing the risk of the thermal propagation.

In some embodiments, as shown in FIG. 5, the method 100 further includes: In S170, in the case that it is determined that the test battery undergoes the thermal propagation, the heating device is controlled to be removed from a test platform, the heating device being configured to heat the test battery to meet the second preset condition.

Optionally, the heating device may be removed from the test platform, either manually or under the control of the host computer. For example, the host computer may communicate with the heating device, and once the host computer determines that the test battery undergoes the thermal propagation, it may perform information interaction with the heating device to control the heating device to be removed from the test platform.

Optionally, the heating device is a heating device with a slide rail.

In the embodiments, in the case that it is determined that the test battery undergoes the thermal propagation, the heating device is removed from the test platform, which will reduce the influence of the thermal propagation on the heating device.

In some embodiments, as shown in FIG. 6, S110, that is, triggering the thermal runaway of the first battery cell in the test battery includes: In S111, the heating apparatus in contact with the surface of the first battery cell is activated, such that the first battery cell meets at least one of the following conditions: the voltage of the first battery cell drops to the preset proportion of an initial voltage, the temperature of the first battery cell reaches the temperature threshold, and the temperature rise rate of the first battery cell is not less than the first threshold for more than the second preset duration.

Before the thermal propagation test is performed on the test battery, the test battery may be first modified by mounting at least the heating apparatus inside the test battery, such that the heating apparatus is in contact with the surface of the first battery cell.

In some embodiments, a planar or rod-shaped heating apparatus may be used, and its surface should be covered with a ceramic, metal, or an insulating layer. For a block-shaped heating apparatus having the same dimensions as battery cells, the heating apparatus may be used to replace one of the battery cells and be in direct contact with the surface of the first battery cell. For a thin-film heating apparatus, it should always be attached to the surface of the first battery cell. The heating area of the heating apparatus should not exceed the surface area of the battery cell, and the heating surface of the heating apparatus is in direct contact with the surface of the first battery cell. The position of the heating apparatus should correspond to the position of the temperature sensor. The power requirements of the heating apparatus are shown in Table 2. When the thermal runaway occurs or the temperature monitored by the temperature sensor reaches 300 °C, the heating is stopped.

**Table 2**

| Electrical energy E (Wh) of the first battery cell | Maximum power of the heating apparatus (W) |
|---|---|
| E<100 | 30~300 |
| 100≤E<400 | 300~1000 |
| 400≤E<800 | 300~2000 |
| E≥800 | >600 |

In some other embodiments, a heating apparatus may also be disposed inside the first battery cell; that is, the heating apparatus is disposed in a housing of the first battery cell. For example, the heating apparatus may be connected to the inner wall of the housing of the first battery cell. For another example, the heating apparatus may also be connected to an electrode assembly within the first battery cell, such as by interposing the heating apparatus between two electrode assemblies.

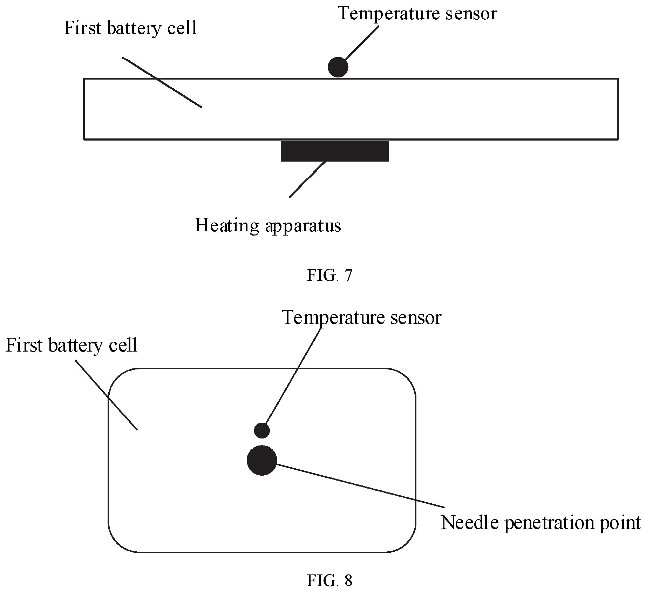

Not only should a heating apparatus be arranged inside the first battery cell, but a sensor, such as a temperature sensor, should also be arranged to monitor whether the first battery cell undergoes the thermal runaway. The corresponding position of the temperature sensor relative to the heating apparatus may be as shown in FIG. 7. That is, the temperature sensor is arranged on the opposite side of the heating device. Optionally, a sampling interval for temperature data should be less than 1 s, with an accuracy requirement of ±2°C.

In the embodiments, the use of the method that triggers the thermal runaway may reduce the probability of damaging the battery cell or an external structure or a sealing structure of the test battery, thereby allowing a simulated thermal runaway behavior to be as realistic as possible.

Optionally, for a heating film, the dimensions may be 30 × 30 mm, and the resistance value may be approximately 50 Ω. Specifically, the heating film may be led out of the test battery, and an external voltage greater than 42 V may be applied. When the first battery cell inside the test battery undergoes the thermal runaway, the heating is stopped.

In some other embodiments, a method for triggering the thermal runaway by needle penetration may also be used. Specifically, the needle for penetration is made of steel and is directly greater than 3 mm to 8 mm, the tip of the needle is conical with an angle of 20° to 60°, and a penetration speed of the needle is 0.1 mm/s to 10 mm/s. A position and direction capable of triggering the thermal runaway in the first battery cell are selected. For example, a direction perpendicular to an electrode plate of the first battery cell is selected. During needle penetration triggering, the position of the temperature sensor should be as proximal as possible to the needle penetration point, as shown in FIG. 8.

In some embodiments, triggering the thermal runaway of the first battery cell in the test battery includes: activating the heating apparatus in contact with the surface of the first battery cell, such that the first battery cell meets at least one of the following conditions: the voltage of the first battery cell drops to a value lower than 25% of the initial voltage, the temperature of the first battery cell reaches the maximum operating temperature specified by the manufacturer, and the temperature rise rate of the first battery cell is not less than 1 °C/s for more than 3 s.

It should be understood that, for a method for determining whether the first battery cell undergoes the thermal runaway, reference may be made to a method for determining whether the second battery cell undergoes the thermal runaway. For brevity, details are not described herein again.

In some embodiments, the test battery is a battery provided with a customized vehicle frame.

Since the mounting position of the battery in the vehicle is mostly located at the chassis, the battery is in a non-free state in this case, and once the thermal runaway occurs, it may affect the exhaust path. Therefore, during the thermal propagation test, the state of the test battery in the vehicle should be reproduced as much as possible, and the vehicle frame is customized and mounted according to a gap between the test battery and the vehicle frame, as well as the obstruction of the pressure relief mechanism, such that the environment for the thermal propagation test is more realistic and the test results are more accurate.

After the thermal propagation test results, the test battery may be left to stand for 2 h, or a surface temperature of the test battery may be reduced to below 45 °C. In addition, after the thermal propagation test is performed on the test battery, it is also necessary to check whether phenomena such as fire or explosion occur in the test battery.

In some embodiments, before the thermal propagation test is performed on the test battery, the test battery needs to be in the following operating manners: 1. A power supply line is powered on, a wake-up signal is activated, CAN communication and other initialization functions are activated, and other functions are not enabled. 2. All protection devices that affect functions of the test battery and are related to the test results should be in a normal operating state, and all related main contactors for discharging should be closed.

The following pretreatment needs to be performed on the test battery before the thermal propagation test is performed on the test battery. Specifically, an insulation test is first performed on the test battery. The measurement voltage used should be 1.5 times the nominal voltage of the test battery or a voltage of 500 (d.c.), whichever is higher. The applied voltage should be maintained for a sufficient duration to obtain a stable reading, and the recommended measurement duration is 30 s. Second, a communication check is performed on the test battery. That is, the power supply line is powered on, the wake-up signal is activated, the CAN communication and other initialization functions are activated. Voltage and temperature sampling are checked to ensure that no abrupt changes occur and that no fault signals are reported.

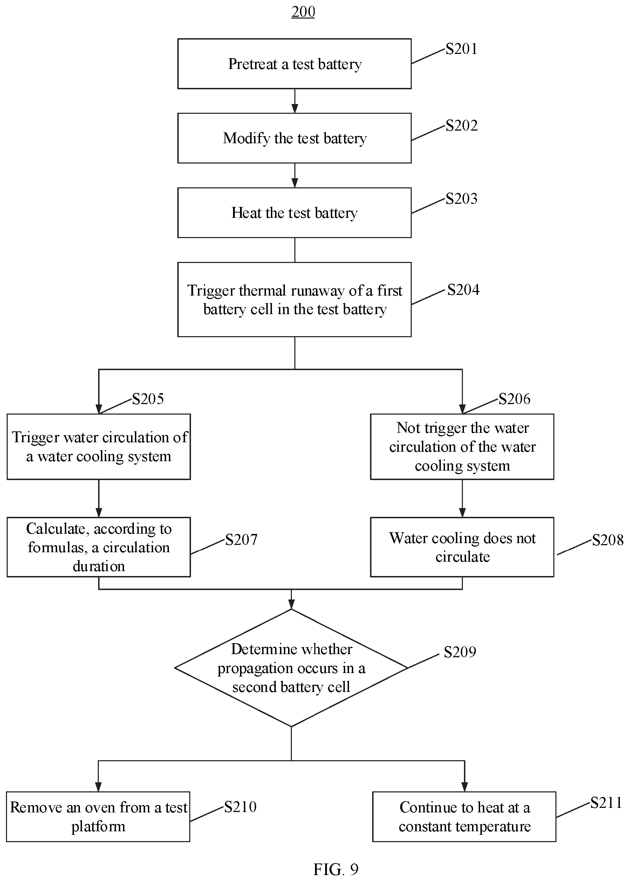

FIG. 9 shows a schematic flowchart of a thermal propagation test method 200 according to an embodiment of the present application. Optionally, as shown in FIG. 9, the method 200 may include some or all of the following contents.

In S201, a test battery is pretreated. For example, the pretreatment includes performing an insulation test on the test battery. For another example, a communication check is performed on the test battery. For another example, the test battery is charged to 100% SOC.

In S202, the test battery is modified. For example, a heating apparatus is provided inside the test battery. For another example, the test battery is mounted on a customized vehicle frame.

In S203, the test battery is placed in an oven, and the test battery is heated to meet a second preset condition. For example, the test battery is heated to 55 °C.

In S204, a triggering method is selected to trigger thermal runaway of a first battery cell in the test battery. For example, a heating apparatus that is in contact with the surface of the first battery cell may be activated to heat the first battery cell until the thermal runaway occurs.

In S205, water circulation of a water cooling system of the test battery is triggered.

In S206, water circulation of a water cooling system of the test battery is not triggered.

In S207, if the water circulation of the water cooling system is triggered, a circulation duration may be calculated according to formulas. For example, the circulation duration may be calculated according to the following formulas: W₁ = C × V × (SOC₁ - SOC₂), and T = W₁/W₂ × 60, where W₁ represents rated energy of a low-voltage power supply provided by the test battery, with a unit of wh, C represents a rated capacity of the low-voltage power supply provided by the test battery, with a unit of Ah, V represents a rated voltage of the low-voltage power supply provided by the test battery, with a unit of V, SOC₁ represents an upper limit value of an SOC at which the test battery operates, with a unit of %, SOC₂ represents a lower limit value of the SOC at which the test battery operates, with a unit of %, W₂ represents rated energy of a water pump, with a unit of wh, and T represents a first preset duration, that is, a duration of the water circulation when powered only by the low-voltage power supply, with a unit of min.

In S208, if the water circulation of the water cooling system is not triggerable, water cooling does not circulate.

In S209, whether propagation occurs in a second battery cell may be further determined. For example, similar to determining whether the first battery cell undergoes the thermal runaway, monitored battery parameter information of the second battery cell may be used to determine whether the second battery cell undergoes the thermal runaway. Once the second battery cell undergoes the thermal runaway, it is considered that the thermal runaway in the first battery cell propagates to the second battery cell.

In S210, if it is determined that the propagation occurs in the second battery cell, the oven is removed from a test platform.

In S211, if it is determined that the propagation does not occur in the second battery cell, heating at a constant temperature may continue until the test is completed.

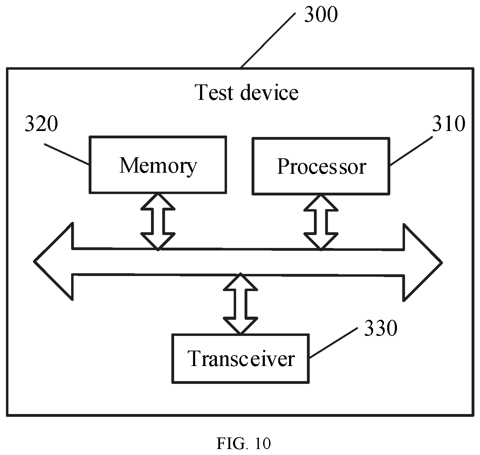

The thermal propagation test method according to the embodiments of the present application is described in detail above. The following describes in detail a test device according to the embodiments of the present application with reference to FIG. 10. Technical features described in the method embodiments are applicable to the following apparatus embodiments.

FIG. 10 shows a schematic block diagram of a test device 300 according to an embodiment of the present application. As shown in FIG. 10, the test device 300 includes some or all of the following contents.

A processor 310 is configured to trigger thermal runaway of a first battery cell in a test battery, a charge level of the test battery meeting a first preset condition, and a temperature of the test battery meeting a second preset condition; the processor 310 is further configured to acquire battery parameter information of a second battery cell in the test battery, the second battery cell being in a first positional relationship with the first battery cell; and the processor 310 is further configured to determine, based on the battery parameter information of the second battery cell, whether the test battery undergoes thermal propagation.

Optionally, in the embodiments of the present application, the temperature of the test battery meeting the second preset condition includes that the temperature of the test battery is not less than 40 °C.

Optionally, in the embodiments of the present application, the charge level of the test battery meeting the first preset condition includes that a state of charge of the test battery reaches 100%.

Optionally, in the embodiments of the present application, the second battery cell being in the first positional relationship with the first battery cell includes that the second battery cell is adjacent to the first battery cell.

Optionally, in the embodiments of the present application, the first battery cell is proximal to a central position within the test battery, and/or the first battery cell is surrounded by other battery cells within the test battery.

Optionally, in the embodiments of the present application, the processor 310 is further configured to: activate, before or after triggering the thermal runaway of the first battery cell in the test battery, a cooling system of the test battery.

Optionally, in the embodiments of the present application, the cooling system is a water cooling system, and the processor 310 is further configured to: control the water cooling system to circulate water for a first preset duration, where the first preset duration is determined based on at least one type of information of the following information: rated energy of a low-voltage power supply provided by the test battery, a rated capacity of the low-voltage power supply provided by the test battery, a rated voltage of the low-voltage power supply provided by the test battery, an upper limit value of a SOC at which the test battery operates, a lower limit value of the SOC at which the test battery operates, and rated energy of a water pump.

Optionally, in the embodiments of the present application, the first preset duration is determined based on the following formulas: W₁ = C × V × (SOC₁ - SOC₂), and T = W₁/W₂ × 60, where W₁ represents the rated energy of the low-voltage power supply provided by the test battery, C represents the rated capacity of the low-voltage power supply provided by the test battery, V represents the rated voltage of the low-voltage power supply provided by the test battery, SOC₁ represents the upper limit value of the SOC at which the test battery operates, SOC₂ represents the lower limit value of the SOC at which the test battery operates, W₂ represents the rated energy of the water pump, and T represents the first preset duration.

Optionally, in the embodiments of the present application, the processor 310 is specifically configured to: determine that the test battery undergoes the thermal propagation in the case that it is monitored that the battery parameter information meets at least one type of the following conditions: a voltage of the second battery cell drops to a value lower than a preset proportion of an initial voltage, a temperature of the second battery cell reaches a temperature threshold, and a temperature rise rate of the second battery cell is not less than a first threshold for more than a second preset duration.

Optionally, in the embodiments of the present application, the processor 310 is specifically configured to: control, before triggering the thermal runaway of the first battery cell in the test battery, a heating device to heat the test battery to meet the second preset condition.

Optionally, in the embodiments of the present application, the processor 310 is further configured to: control, in the case that it is determined that the test battery undergoes the thermal propagation, the heating device to be removed from a test platform.

Optionally, in the embodiments of the present application, the processor 310 is specifically configured to: activate a heating apparatus in contact with the surface of the first battery cell, such that the first battery cell meets at least one type of the following conditions: a voltage of the first battery cell drops to a value lower than the preset proportion of an initial voltage, a temperature of the first battery cell reaches the temperature threshold, and a temperature rise rate of the first battery cell is not less than the first threshold for more than the second preset duration.

Optionally, in the embodiments of the present application, the test battery is a battery provided with a customized vehicle frame.

Optionally, as shown in FIG. 10, the test device further includes a memory 320, where the memory 320 is configured to store instructions, and the processor 310 is configured to read the instructions and execute the method according to the foregoing embodiments of the present application based on the instructions.

The memory 320 may be a separate device independent of the processor 310, or may be integrated into the processor 310.

Optionally, the test device 300 may further include a transceiver 330, and the processor 310 may control the transceiver 330 to communicate with another device. Specifically, the transceiver may send information or data to another device, or receive information or data sent by another device.

It should be understood that modules or units in the test device 300 are capable of implementing the corresponding processes in the thermal propagation test method according to the embodiments of the present application. For brevity, details are not described herein again.

The embodiments of the present application further provide a chip. The chip includes a processor configured to invoke a computer program from a memory and run the computer program, such that a device provided with the chip performs the method according to the foregoing embodiments of the present application.

It should be understood that the processor according to the embodiments of the present application may be an integrated circuit chip with a signal processing capability. During the implementation process, the steps in the above method embodiments may be implemented via an integrated logic circuit of hardware in the processor, or via an instruction in the form of software. The above processor may be a general-purpose processor, a digital signal processor (DSP), an application specific integrated circuit (ASIC), a field-programmable gate array (FPGA) or another programmable logic device, a discrete gate or a transistor logic device, a discrete hardware component, or the like. The processor may implement or execute the methods, steps, and logic block diagrams disclosed in the embodiments of the present application. The general-purpose processor may be a microprocessor or the processor may be any conventional processor. The steps of the methods disclosed in the embodiments of the present application may be directly executed by a hardware-based decoding processor, or may be executed by a combination of hardware and software modules in the decoding processor. The software module may be located in a mature storage medium in the art, such as a random access memory, a flash memory, a read-only memory, a programmable read-only memory, an electrically erasable programmable memory, and a register. The storage medium resides in the memory. The processor reads information in the memory and completes the steps in the above methods in combination with the hardware thereof.

It should be understood that the memory in the embodiments of the present application may be a volatile memory or a non-volatile memory, or may include both volatile and non-volatile memories. The non-volatile memory may be a read-only memory (ROM), a programmable ROM (PROM), an erasable PROM (EPROM), an electrically EPROM (EEPROM), or a flash memory. The volatile memory may be a random access memory (RAM) that serves as an external cache. By way of example but not limitation, many forms of RAMs are available, for example, a static RAM (SRAM), a dynamic RAM (DRAM), a synchronous DRAM (SDRAM), a double data rate SDRAM (DDR SDRAM), an enhanced SDRAM (ESDRAM), a synchlink DRAM (SLDRAM), and a direct rambus RAM (DR RAM). It should be noted that the memory of the systems and methods described herein is intended to include, but is not limited to these and any other suitable types of memory.

The embodiments of the present application further provide a computer storage medium. The computer storage medium is configured to store a computer program, and the computer program is used to perform the methods according to the foregoing embodiments of the present application.

Optionally, the computer-readable storage medium may be applied in the test device in the embodiments of the present application, and the computer program causes a computer to perform the corresponding processes implemented by the test device in the methods according to the embodiments of the present application. For brevity, details are not described herein again.

The embodiments of the present application further provide a computer program product. The computer program product includes a computer program instruction.

Optionally, the computer program product may be applied in the test device in the embodiments of the present application, and the computer program instruction causes a computer to perform the corresponding processes implemented by the test device in the methods according to the embodiments of the present application. For brevity, details are not described herein again.

The embodiments of the present application further provide a computer program.

Optionally, the computer program may be applied in the test device in the embodiments of the present application, and the computer program, when running on a computer, causes the computer to perform the corresponding processes implemented by the test device in the methods according to the embodiments of the present application. For brevity, details are not described herein again.

The above descriptions are only embodiments of the present application, but the protection scope of the present application is not limited thereto. Any variations or substitutions that may be easily conceived by those skilled in the art within the technical scope disclosed in the present application shall be covered by the protection scope of the present application. Therefore, the protection scope of the present application shall be subject to the protection scope of the claims described.

## Claims

1. A thermal propagation test method, comprising:
triggering thermal runaway of a first battery cell in a test battery, a charge level of the test battery meeting a first preset condition, and a temperature of the test battery meeting a second preset condition;
acquiring battery parameter information of a second battery cell in the test battery, the second battery cell being in a first positional relationship with the first battery cell; and
determining, based on the battery parameter information of the second battery cell, whether the test battery undergoes thermal propagation.

2. The method according to claim 1, wherein the temperature of the test battery meeting the second preset condition comprises that the temperature of the test battery is not less than 40 °C.

3. The method according to claim 1 or 2, wherein the charge level of the test battery meeting the first preset condition comprises that a state of charge of the test battery reaches 100%.

4. The method according to any one of claims 1 to 3, wherein the second battery cell being in the first positional relationship with the first battery cell comprises that the second battery cell is adjacent to the first battery cell.

5. The method according to any one of claims 1 to 4, wherein the first battery cell is proximal to a central position within the test battery, and/or the first battery cell is surrounded by other battery cells within the test battery.

6. The method according to any one of claims 1 to 5, wherein before or after triggering the thermal runaway of the first battery cell in the test battery, the method further comprises: activating a cooling system of the test battery.

7. The method according to claim 6, wherein the cooling system is a water cooling system, and the method further comprises:
controlling the water cooling system to circulate water for a first preset duration,
wherein the first preset duration is determined based on at least one type of information of the following information: rated energy of a low-voltage power supply provided by the test battery, a rated capacity of the low-voltage power supply provided by the test battery, a rated voltage of the low-voltage power supply provided by the test battery, an upper limit value of a state of charge at which the test battery operates, a lower limit value of the state of charge at which the test battery operates, and rated energy of a water pump.

8. The method according to claim 7, wherein the first preset duration is determined based on the following formulas: W₁ = C × V × (SOC₁ - SOC₂), and T = W₁/W₂ × 60, wherein W₁ represents the rated energy of the low-voltage power supply provided by the test battery, C represents the rated capacity of the low-voltage power supply provided by the test battery, V represents the rated voltage of the low-voltage power supply provided by the test battery, SOC₁ represents the upper limit value of the state of charge at which the test battery operates, SOC₂ represents the lower limit value of the state of charge at which the test battery operates, W₂ represents the rated energy of the water pump, and T represents the first preset duration.

9. The method according to any one of claims 1 to 8, wherein said determining, based on the battery parameter information of the second battery cell, whether the test battery undergoes the thermal propagation comprises:
determining that the test battery undergoes the thermal propagation in a case that it is monitored that the battery parameter information meets at least one type of the following conditions:
a voltage of the second battery cell drops to a value lower than a preset proportion of an initial voltage;
a temperature of the second battery cell reaches a temperature threshold; and
a temperature rise rate of the second battery cell is not less than a first threshold for more than a second preset duration.

10. The method according to any one of claims 1 to 9, further comprising:
heating, before triggering the thermal runaway of the first battery cell in the test battery, the test battery to meet the second preset condition.

11. The method according to claim 10, further comprising:
controlling, in a case that it is determined that the test battery undergoes the thermal propagation, a heating device to be removed from a test platform, the heating device being configured to heat the test battery to meet the second preset condition.

12. The method according to any one of claims 1 to 11, wherein said triggering the thermal runaway of the first battery cell in the test battery comprises:
activating a heating apparatus in contact with a surface of the first battery cell, such that the first battery cell meets at least one type of the following conditions:
a voltage of the first battery cell drops to a value lower than a preset proportion of an initial voltage;
a temperature of the first battery cell reaches a temperature threshold; and
a temperature rise rate of the first battery cell is not less than a first threshold for more than a second preset duration.

13. The method according to any one of claims 1 to 12, wherein the test battery is a battery provided with a customized vehicle frame.

14. A test device, wherein the test device is configured to perform a thermal propagation test on a test battery, and the test device comprises a processor, wherein:
the processor is configured to trigger thermal runaway of a first battery cell in the test battery, a charge level of the test battery meeting a first preset condition, and a temperature of the test battery meeting a second preset condition;
the processor is further configured to acquire battery parameter information of a second battery cell in the test battery, the second battery cell being in a first positional relationship with the first battery cell; and
the processor is further configured to determine, based on the battery parameter information of the second battery cell, whether the test battery undergoes thermal propagation.

15. The test device according to claim 14, wherein the temperature of the test battery meeting the second preset condition comprises that the temperature of the test battery is not less than 40 °C.

16. The test device according to claim 14 or 15, wherein the charge level of the test battery meeting the first preset condition comprises that a state of charge of the test battery reaches 100%.

17. The test device according to any one of claims 14 to 16, wherein the second battery cell being in the first positional relationship with the first battery cell comprises that the second battery cell is adjacent to the first battery cell.

18. The test device according to any one of claims 14 to 17, wherein the first battery cell is proximal to a central position within the test battery, and/or the first battery cell is surrounded by other battery cells within the test battery.

19. The test device according to any one of claims 14 to 18, wherein the processor is further configured to:
activate, before or after triggering the thermal runaway of the first battery cell in the test battery, a cooling system of the test battery.

20. The test device according to claim 19, wherein the cooling system is a water cooling system, and the processor is further configured to:
control the water cooling system to circulate water for a first preset duration,
wherein the first preset duration is determined based on at least one type of information of the following information: rated energy of a low-voltage power supply provided by the test battery, a rated capacity of the low-voltage power supply provided by the test battery, a rated voltage of the low-voltage power supply provided by the test battery, an upper limit value of a state of charge at which the test battery operates, a lower limit value of the state of charge at which the test battery operates, and rated energy of a water pump.

21. The test device according to claim 20, wherein the first preset duration is determined based on the following formulas: W1 = C × V × (SOC₁ - SOC₂), and T = W₁/W₂ × 60, wherein W₁ represents the rated energy of the low-voltage power supply provided by the test battery, C represents the rated capacity of the low-voltage power supply provided by the test battery, V represents the rated voltage of the low-voltage power supply provided by the test battery, SOC₁ represents the upper limit value of the state of charge at which the test battery operates, SOC₂ represents the lower limit value of the state of charge at which the test battery operates, W₂ represents the rated energy of the water pump, and T represents the first preset duration.

22. The test device according to any one of claims 14 to 21, wherein the processor is specifically configured to:
determine that the test battery undergoes the thermal propagation in a case that it is monitored that the battery parameter information meets at least one type of the following conditions:
a voltage of the second battery cell drops to a value lower than a preset proportion of an initial voltage;
a temperature of the second battery cell reaches a temperature threshold; and
a temperature rise rate of the second battery cell is not less than a first threshold for more than a second preset duration.

23. The test device according to any one of claims 14 to 22, wherein the processor is specifically configured to:
control, before triggering the thermal runaway of the first battery cell in the test battery, a heating device to heat the test battery to meet the second preset condition.

24. The test device according to claim 23, wherein the processor is further configured to:
control, in a case that it is determined that the test battery undergoes the thermal propagation, the heating device to be removed from a test platform.

25. The test device according to any one of claims 14 to 24, wherein the processor is specifically configured to:
activate a heating apparatus in contact with a surface of the first battery cell, such that the first battery cell meets at least one type of the following conditions:
a voltage of the first battery cell drops to a value lower than a preset proportion of an initial voltage;
a temperature of the first battery cell reaches a temperature threshold; and
a temperature rise rate of the first battery cell is not less than a first threshold for more than a second preset duration.

26. The test device according to any one of claims 14 to 25, wherein the test battery is a battery provided with a customized vehicle frame.

27. A computer-readable storage medium, wherein the computer-readable storage medium is configured to store a computer program, and the computer program causes a computer to perform the test method according to any one of claims 1 to 13.
